# EUROPÄISCHE PATENTSCHRIFT

(11) **EP 1 672 797 B1**
(45) Veröffentlichungstag und Bekanntmachung des Hinweises auf die Patenterteilung: **29.07.2009**
(21) Anmeldenummer: 05026784.8
(22) Anmeldetag: 08.12.2005
(51) Int. Cl.: H03K 17/96

(54) **Kapazitiver Berührungsschalter**
Capacitive touch switch
Commande tactile à capteurs capacitifs

(30) Priorität: 17.12.2004 DE 102004060846
(43) Veröffentlichungstag der Anmeldung: 21.06.2006
(73) Patentinhaber: Diehl AKO Stiftung & Co. KG, 88239 Wangen (DE)
(72) Erfinder: Kaps, Werner, 88171 Weiler-Simmerberg (DE); Heimann, Uwe, 90427 Nürnberg (DE)
(74) Vertreter: Diehl Patentabteilung

(56) Entgegenhaltungen:
- EP-A- 1 257 057
- EP-A- 1 416 636
- US-A- 4 379 287
- US-A- 4 380 007
- US-A- 5 917 165
- BURK A: "MOMENTARY SWITCHING ALTERNATIVES FOR KEY PAD AND FRONT PANEL APPLICATIONS" ELECTRO INTERNATIONAL CONFERENCE RECORD, WESTERN PERIODICALS CO, VENTURA, CA, US, Bd. 18, Januar 1993 (1993-01), Seiten 282-291, XP000381927

## Beschreibung

Die Erfindung betrifft einen kapazitiven Berührungsschalter mit einem zwischen einer Platine und einer Abdeckplatte angeordneten flexiblen Körper, insbesondere aus einem Schaumstoff. Ein derartiger Berührungsschalter ist beispielsweise aus der EP 0 859 467 B1 bekannt.

Der aus der EP 0 859 467 B1 bekannte Berührungsschalter weist einen auf einer metallischen Kontaktfläche einer Platine angeordneten flexiblen Körper auf, der den Raum zwischen der Platine und einer Abdeckplatte überbrückt. Zur Herstellung einer elektrischen Leitfähigkeit des Körpers, insbesondere Schaumstoffkörpers, ist in diesen beispielsweise Kohlenstoff eingelagert. Ein hoher elektrischer Widerstand des Schaumstoffkörpers von beispielsweise 500 Kiloohm soll zu einer guten elektromagnetischen Verträglichkeit (EMV), insbesondere einer Filterwirkung gegenüber elektrischen Störgrößen, beitragen.

Ferner offenbart die US-A- 4,379,287 einen kapazitiven Berührungsschalter mit einer Sensortaste, die zwischen einer Platine und einer Abdeckplatte angeordnet ist und aus einem elastischen Band aus einem dielektrischen Material, auf dessen beiden Hauptseiten Leitfähige kondensatorplatten vorgesehen sind, gebildet ist.

Der Erfindung liegt die Aufgabe zugrunde, einen kapazitiven Berührungsschalter anzugeben, welcher sich durch eine besonders günstige Kombination mechanischer und elektrischer Eigenschaften auszeichnet.

Diese Aufgabe wird erfindungsgemäß gelöst durch einen kapazitiven Berührungsschalter mit den Merkmalen des Anspruches 1. Dieser Berührungsschalter umfasst einen ein Teil einer Sensortaste bildenden flexiblen Körper, der zwischen einer Platine und einer Abdeckplatte angeordnet ist. Der Körper ist erfindungsgemäß von einem leitfähigen Netz umspannt. Damit sind die elektrischen Eigenschaften des Körpers ohne Beeinträchtigung der mechanischen Eigenschaften wesentlich verbessert. Insbesondere ist der Kontaktwiderstand zwischen der Sensortaste und einer Kontaktfläche auf der angrenzenden Platine herabgesetzt.

Der in sich flexible Körper, insbesondere Schaumstoffkörper, der Sensortaste ist vorzugsweise ein elektrischer Isolator. Als Material zur Herstellung des elastischen Körpers ist beispielsweise ein weichelastischer Kunststoff, Naturgummi, synthetischer Gummi, Silicon oder ein sonstiges weiches, insbesondere schäumbares Material geeignet. In jedem Fall ist die spezifische elektrische Leitfähigkeit des Körpers geringer als diejenige des um den Körper gelegten Netzes. Der Körper kann unterschiedlichste geometrische Formen, beispielsweise ein zylindrische Form, aufweisen. In bevorzugter Ausgestaltung hat der Körper die Form eines Quaders, insbesondere mit einer quadratischen Querschnittsfläche. Das leitfähige Netz ist wie ein Schlauch über den Körper gezogen oder wie ein Tuch um den Körper gelegt, so dass es diesen, im Fall einer Quaderform, auf vier Seiten bedeckt. In jedem Fall ist sowohl die der Platine zugewandte als auch die der Abdeckplatte zugewandte Seite des Körpers von dem leitfähigen Netz bedeckt.

Das leitfähige Netz kann beispielsweise aus einem Metallgeflecht bestehen. Der Begriff "Netz" ist in einem sehr weiten Sinn zu verstehen und umfasst beispielsweise auch ein Vlies sowie eine Drahtwicklung. Vorzugsweise ist das Netz aus einem metallisierten, d.h. mit einem metallischen Überzug versehenen Gewebe eines Nichtleiters, beispielsweise Nylon oder einer anderen Kunstfaser, gebildet. Auf die mechanischen Eigenschaften des elastischen Körpers hat das leitfähige Netz praktisch keine Auswirkungen.

Nach einer bevorzugten Ausgestaltung ist auf der Platine mindestens ein Leuchtmittel, insbesondere eine Leuchtdiode, angeordnet. Um die Sensortaste oder einen an die Sensortaste grenzenden Bereich der Abdeckplatte zu beleuchten, kann das von dem Leuchtmittel emittierte Licht durch eine Öffnung im Körper geleitet werden. Von besonderem Vorteil ist dabei die Anordnung eines Lichtleiters in der Öffnung des flexiblen Körpers. Vorzugsweise ist der Lichtleiter aus einem elastisch nachgiebigen Material, insbesondere Silicon, gefertigt, um sich der Form des flexiblen Körpers anpassen zu können.

Die mindestens eine Sensortaste auf der Platine ist, in Draufsicht auf die Platine, nach einer vorteilhaften Weiterbildung in eine Matte aus elastischem Material, insbesondere eine Silconmatte, eingebettet. Somit ist die Sensortaste allseitig, mit Ausnahme derjenigen Seiten, die der Platine oder der Abdeckplatte zugewandt sind, von dem elastischem Material umgeben. Die Matte hat zum einen die Funktion, die Sensortaste beziehungsweise die Sensortasten an der vorgesehenen Stelle auf der Platine zu halten und erleichtert damit eine sehr rationelle Montage. Zum anderen hat die Matte auch eine abdichtende Funktion, wobei die Außenkonturen der Matte bevorzugt zumindest annähernd den Konturen der Platine sowie der Abdeckplatte entsprechen. Darüber hinaus kann die Matte auch als lichtleitendes Element dienen. Insbesondere ist es möglich, das von einem auf der Platine angeordneten Leuchtmittel emittierte Licht durch die Matte zu leiten. Der oben im Zusammenhang mit einer Leuchtdiode genannte Lichtleiter kann also einteilig mit der die Sensortaste umschließenden Matte ausgebildet sein. Alternativ ist es auch möglich, in Öffnungen der Matte separate Lichtleiter einzusetzen.

Die vorzugsweise aus Kunststoff gefertigte Abdeckplatte ist im Wesentlichen parallel zur Platine angeordnet. Eine besonders ergonomische Gestaltung kann in vielen Anwendungsfällen dadurch erreicht werden, dass die Abdeckplatte eine zumindest leichte Krümmung aufweist. Der Abstand zwischen der Abdeckplatte und der Platine ist somit nicht an allen Stellen gleich. Den variierenden Abständen zwischen der Abdeckplatte und der Platine passt sich der flexible, mit einem leitfähigen Netz umspannte Körper an. Bei Bedarf können auf einer einzigen Platine auch Sensortasten unterschiedlicher Abmessungen montiert werden.

Die Sensortaste bildet einen Pol eines Kondensators, der durch Auflegen eines Fingers einer Bedienperson auf die Abdeckplatte in seiner Kapazität verändert werden kann. Die elektrischen Eigenschaften des Kondensators sind gezielt beeinflussbar, indem die der Platine zugewandte Oberfläche der Abdeckplatte leitfähig beschichtet wird. Als leitfähige Schicht, die mit dem den Körper umspannenden Netz in elektrischem Kontakt ist, kommt insbesondere eine metallische Beschichtung einer Kunststofffolie in Betracht. Nach einer alternativen Ausgestaltung befindet sich auf der äußeren, d.h. der Platine abgewandten Oberfläche der Abdeckplatte eine leitfähige Schicht, insbesondere eine metallisierte Folie.

Nachfolgend werden zwei Ausführungsbeispiele der Erfindung anhand einer Zeichnung näher erläutert. Hierin zeigen:

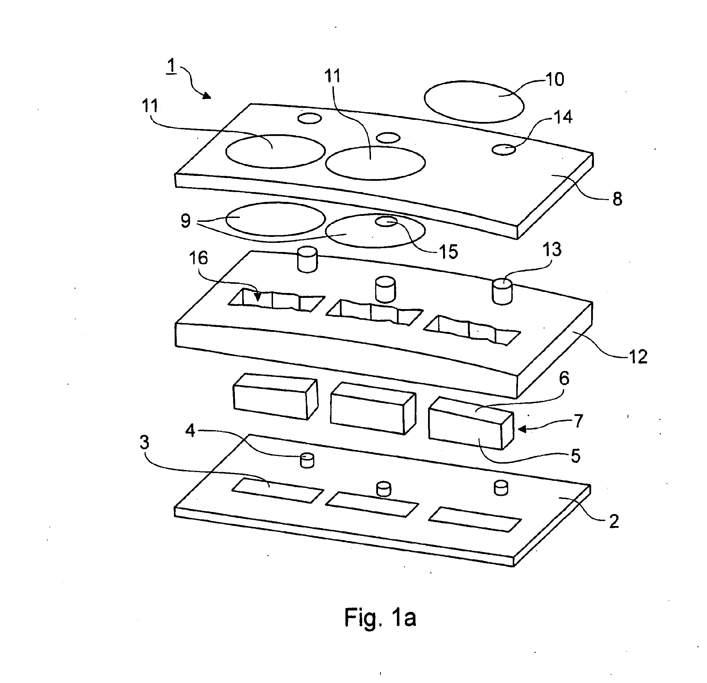

- Fig. 1a: in einer Explosionsdarstellung ein erstes Ausführungsbeispiel eines kapazitiven Berührungsschalters,
- Fig. 1 b: eine Sensortaste des Berührungsschalters nach Fig. 1a, und
- Fig. 2a-2f: in einer perspektivischen Darstellung, einer Draufsicht sowie verschiedenen Schnitten ein zweites Ausführungsbeispiel eines kapazitiven Berührungsschalters.

Einander entsprechende oder gleich wirkende Teile sind in allen Figuren mit denselben Bezugszeichen versehen.

Ein in Fig. 1a dargestellter kapazitiver Berührungsschalter 1 weist eine Leiterplatte oder Platine 2 mit mehreren rechteckigen Kontaktflächen 3 sowie nicht gezeigten Leiterbahnen auf. Des Weiteren befinden sich auf der Platine 2 mehrere Leuchtdioden 4, allgemein als Leuchtmittel bezeichnet. Die Kontaktflächen 3 werden kontaktiert von jeweils einer Sensortaste 5, welche aus einem von einem leitfähigen Netz 6 umspannten quaderförmigen Körper 7 aus Schaumstoff gebildet ist. Jede Sensortaste 5 weist damit eine flexible, elastisch nachgiebige Gestalt auf und ist im zusammengebauten Zustand des Berührungsschalters 1 zumindest geringfügig komprimiert, um den vorhandenen Einbauraum in jedem Fall vollständig auszufüllen.

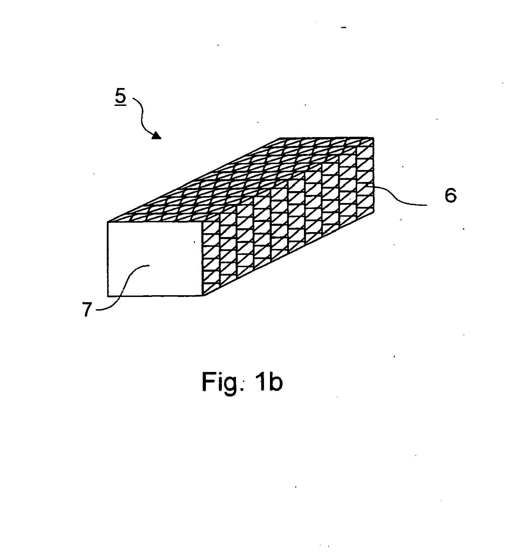

Die Gestaltung der Sensortaste 5 geht im Detail aus Fig. 1 b hervor. Das Netz 6 hat die Form eines um den Körper 7 gelegten Schlauches und ist aus metallisch beschichteten Kunststofffasern, nämlich Nylonfasern, gefertigt. Die Komprimierbarkeit des aus einem isolierenden Material gefertigten Körpers 7 ist durch das Netz 6 praktisch nicht beeinflusst. Auf den von den Kontaktflächen 3 im Wesentlichen parallel beabstandeten Oberseiten der Sensortasten 5 liegt eine leicht gekrümmte, aus Kunststoff gefertigte Abdeckplatte 8 auf, welche als Bedienblende fungiert. An der der Platine 2 zugewandten Oberfläche der Abdeckplatte 8 befinden sich zwei kreisrunde metallisierte Folien 9, die jeweils eine Sensortaste 5 kontaktieren. Die Anordnung aus leitfähiger Folie 9, Sensortaste 5 und Kontaktfläche 3 bildet insgesamt einen Pol eines Kondensators. Nach einer alternativen Ausgestaltung befindet sich eine metallisierte Folie 10 auf der Oberseite, d.h. der der Platine 2 abgewandten Seite der Abdeckplatte 8. Soweit sich keine metallisierte Folie auf der Oberseite der Abdeckplatte 8 befindet, ist diese mit einem Farbdruck 11 versehen, dessen Fläche der Fläche der metallisierten Folie 9 entspricht. Der Berührungsschalter kann aber auch ganz ohne metallisierte Folien 9, 10 ausgeführt sein.

Der Raum zwischen der Platine 2 und der Abdeckplatte 8 ist weitgehend ausgefüllt mit einer Matte 12 aus Silicon, welche abdichtende und zugleich lichtleitende Funktion hat. Letztgenannte Funktion ist insbesondere ersichtlich anhand von Lichtleitzylindern 13, die aus der ansonsten im Wesentlichen ebenen Oberfläche der Matte 12 herausragen und kreisrunde Öffnungen 14 in der Abdeckplatte 8 ausfüllen. Soweit sich eine Leuchtdiode 4, in Draufsicht auf die Abdeckplatte 8, im Bereich einer Folie 9 und eines Farbdrucks 11 befindet, wie im Fall der mittleren Sensortaste 5, weist auch die Folie 9 eine der Form des Lichtleitzylinders 13 angepasste Öffnung 15 auf. Die Sensortasten 5 sind in Durchbrüchen 16 der Matte 12 angeordnet, welche im Wesentlichen eine rechteckige Querschnittsform haben. Abweichend von einer exakten Rechteckform sind jedoch die Konturen der Durchbrüche 16 etwas gewellt, um eine einfachere Montage, auch bei geringfügigen Abweichungen von den geometrischen Sollwerten, zu ermöglichen.

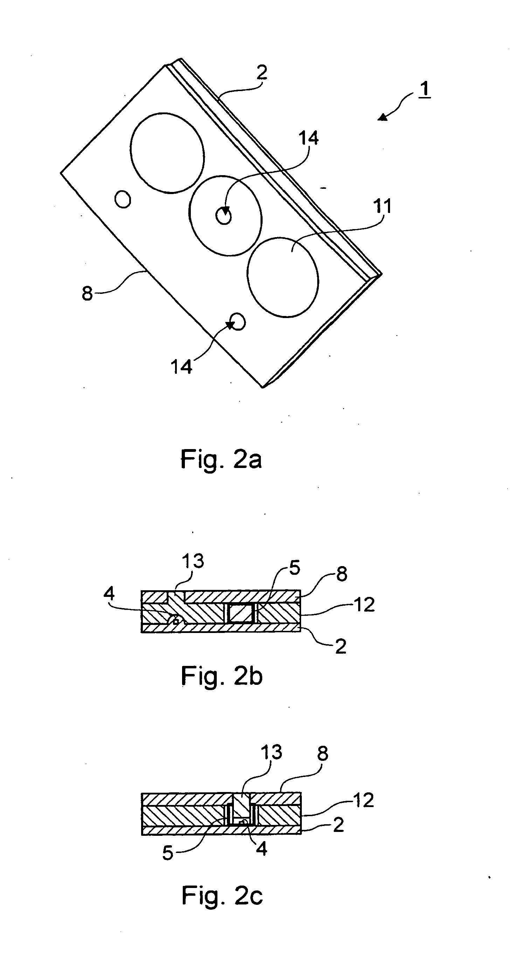

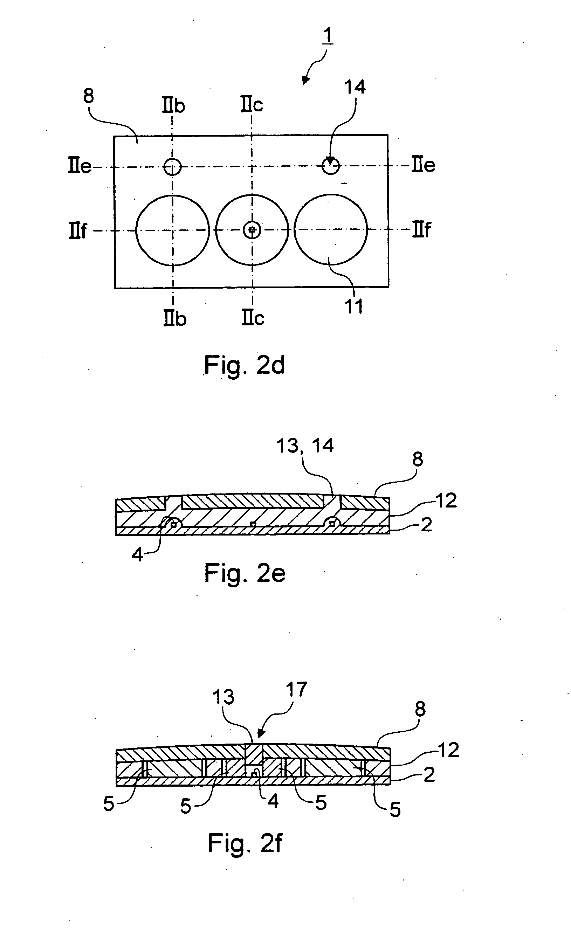

Das Ausführungsbeispiel nach den Fig. 2a bis 2f unterscheidet sich vom Ausführungsbeispiel nach Fig. 1 hauptsächlich durch die Anordnung der Leuchtdioden 4. Die mittlere der Leuchtdioden 4 befindet sich auf der Platine 2 an einer Stelle, an der auch die mittlere Sensortaste 5 auf der Platine 2 aufliegt.

Diese Sensortaste 5 weist daher eine zylindrische Öffnung 17 auf, deren Querschnitt dem Querschnitt des Lichtleitzylinders 13 entspricht. Auf diese Weise ist es möglich, die Leuchtdiode 4 zentriert relativ zur leitfähigen Folie 9 sowie zur Sensortaste 5 anzuordnen.

## Patentansprüche

1. Kapazitiver Berührungsschalter mit einer zwischen einer Platine (2) und einer Abdeckplatte (8) angeordneten Sensortaste (5), welche einen Pol eines Kondensators bildet, der in seiner Kapazität durch Annäherung veränderbar ist, wobei die Sensortaste (5) einen an die Abdeckplatte (8) anpassbaren, elektrisch nicht leitfähigen Körper (7) aus einem flexiblen Material enthält,
**dadurch gekennzeichnet,**
**dass** der Körper (7) von einer elektrisch leitfähigen Schicht zumindest teilweise umgeben ist, wobei der Körper (7) von einem leitfähigen Netz (6) umspannt ist.

2. Berührungsschalter nach Anspruch 1,
**dadurch gekennzeichnet,**
**dass** das leitfähige Netz (6) aus einem metallisierten Gewebe eines Nichtleiters gebildet ist.

3. Berührungsschalter nach Anspruch 1 oder 2,
**dadurch gekennzeichnet,**
**dass** auf der Platine (2) ein Leuchtmittel (4) angeordnet ist.

4. Berührungsschalter nach Anspruch 3,
**dadurch gekennzeichnet,**
**dass** als Leuchtmittel (4) eine Leuchtdiode vorgesehen ist.

5. Berührungsschalter nach Anspruch 3 oder 4,
**dadurch gekennzeichnet,**
**dass** der Körper (7) eine vom vom Leuchtmittel (4) emittierten Licht durchstrahlbare Öffnung (17) aufweist.

6. Berührungsschalter nach Anspruch 5,
**dadurch gekennzeichnet,**
**dass** in der Öffnung (17) ein Lichtleiter (13) angeordnet ist.

7. Berührungsschalter nach Anspruch 6,
**dadurch gekennzeichnet,**
**dass** der Lichtleiter (13) aus einem elastisch nachgiebigen Material, insbesondere Silicon, gebildet ist.

8. Berührungsschalter nach einem der Ansprüche 1 bis 7,
**dadurch gekennzeichnet,**
**dass** die nicht der Platine (2) oder der Abdeckplatte (8) zugewandten Seiten der Sensortaste (5) von einer Matte (12) aus elastischem Material, insbesondere Silicon, umgeben sind.

9. Berührungsschalter nach Anspruch 8,
**dadurch gekennzeichnet,**
**dass** die elastische Matte (12) lichtleitend, insbesondere zur Leitung des von einem Leuchtmittel (4) auf der Platine (2) emittierten Lichtes ausgebildet, ist.

10. Berührungsschalter nach einem der Ansprüche 1 bis 9,
**dadurch gekennzeichnet,**
**dass** die Abdeckplatte (8) gekrümmt ist.

11. Berührungsschalter nach einem der Ansprüche 1 bis 10, **dadurch gekennzeichnet dass** die leitfähige Schicht (9), auf einer Oberfläche der Abdeckplatte (8) angeordnet ist, wobei die leitfähige Schicht (9) vorzugsweise zwischen dem Körper (7) und der Abdeckplatte (8) angeordnet ist.

## Claims

1. Capacitive touch switch having a sensor key (5) which is arranged between a board (2) and a cover panel (8) and forms one pole of a capacitor whose capacitance can be varied by proximity, with the sensor key (5) containing an electrically non-conductive body (7) which can be matched to the cover panel (8) and is composed of a flexible material,
**characterized**
**in that** the body (7) is at least partially surrounded by an electrically conductive layer, with the body (7) being covered by a conductive mesh (6).

2. Touch switch according to Claim 1,
**characterized**
**in that** the conductive mesh (6) is formed by a metallized fabric composed of a non-conductive material.

3. Touch switch according to Claim 1 or 2,
**characterized**
**in that** a light source (4) is arranged on the board (2).

4. Touch switch according to Claim 3,
**characterized**
**in that** a light-emitting diode is provided as the light source (4).

5. Touch switch according to Claim 3 or 4,
**characterized in that** the body (7) has an opening (17) through which light emitted from the light source (4) can pass.

6. Touch switch according to Claim 5,
**characterized**
**in that** an optical waveguide (13) is arranged in the opening (17).

7. Touch switch according to Claim 6,
**characterized**
**in that** the optical waveguide (13) is formed from an elastically flexible material, in particular silicone.

8. Touch switch according to one of Claims 1 to 7,
**characterized**
**in that** those sides of the sensor key (5) which do not face the board (2) or the cover panel (8) are surrounded by a mat (12) composed of elastic material, in particular silicone.

9. Touch switch according to Claim 8,
**characterized**
**in that** the elastic mat (12) conducts light, in particular in order to conduct the light which is emitted from a light source (4) on the board (2).

10. Touch switch according to one of Claims 1 to 9,
**characterized**
**in that** the cover panel (8) is curved.

11. Touch switch according to one of Claims 1 to 10,
**characterized**
**in that** the conductive layer (9) is arranged on one surface of the cover panel (8), with the conductive layer (9) preferably being arranged between the body (7) and the cover panel (8).

## Revendications

1. Détecteur de contact capacitif comprenant une touche de détection (5) disposée entre une platine (2) et une plaque de protection (8), laquelle forme un pôle d'un condensateur dont la capacité peut varier sous l'effet d'une approche, la touche de détection (5) contenant un corps (7) électriquement non conducteur en un matériau souple qui peut s'adapter à la plaque de protection (8), **caractérisé en ce que** le corps (7) est au moins partiellement entouré par une couche électriquement conductrice, le corps (7) étant ainsi ceint par un réseau conducteur (6).

2. Détecteur de contact selon la revendication 1, **caractérisé en ce que** le réseau conducteur (6) est formé par une structure métallisée d'un matériau non conducteur.

3. Détecteur de contact selon la revendication 1 ou 2, **caractérisé en ce qu'**un moyen lumineux (4) est disposé sur la platine (2).

4. Détecteur de contact selon la revendication 3, **caractérisé en ce que** le moyen lumineux (4) prévu est une diode électroluminescente.

5. Détecteur de contact selon la revendication 3 ou 4, **caractérisé en ce que** le corps (7) présente une ouverture (17) qui peut être traversée par la lumière émise par le moyen lumineux (4).

6. Détecteur de contact selon la revendication 5, **caractérisé en ce qu'**une fibre optique (13) est disposée dans l'ouverture (17).

7. Détecteur de contact selon la revendication 6, **caractérisé en ce que** la fibre optique (13) est composée d'un matériau déformable par effet élastique, notamment du silicone.

8. Détecteur de contact selon la revendication 7, **caractérisé en ce que** les côtés de la touche de détection (5) qui ne font pas face à la platine (2) ou à la plaque de protection (8) sont entourés par une natte (12) en matériau élastique, notamment du silicone.

9. Détecteur de contact selon la revendication 8, **caractérisé en ce que** la natte élastique (12) est conductrice de lumière, notamment configurée pour guider la lumière émise par un moyen lumineux (4) sur la platine (2).

10. Détecteur de contact selon l'une des revendications 1 à 9, **caractérisé en ce que** la plaque de protection (8) est courbée.

11. Détecteur de contact selon l'une des revendications 1 à 10, **caractérisé en ce que** la couche conductrice (9) est disposée sur une surface de la plaque de protection (8), la couche conductrice (9) étant de préférence disposée entre le corps (7) et la plaque de protection (8).
